# EUROPEAN PATENT APPLICATION

(11) **EP 4 773 556 A1**
(43) Date of publication of application: **08.07.2026**
(21) Application number: 24859756.9
(22) Date of filing: 27.08.2024
(51) Int. Cl.: H04L 25/03, G06F 13/38

(54) **SEMICONDUCTOR INTEGRATED CIRCUIT AND DATA TRANSFER METHOD**

(30) Priority: 31.08.2023 JP 2023141360
(71) Applicant: Nuvoton Technology Corporation Japan, Nagaokakyo City, Kyoto 617-8520 (JP)
(72) Inventor: FUKUDA, Shohei, Nagaokakyo City, Kyoto 6178520 (JP); KUBO, Kazuyuki, Nagaokakyo City, Kyoto 6178520 (JP)
(74) Representative: Appelt, Christian W.
(86) International application number: PCT/JP2024/030455
(87) International publication number: WO 2025/047724

(57) **Abstract**

A semiconductor integrated circuit (10) for scrambling data and transferring the data to a transfer destination circuit (90) includes: a scrambler (50) that generates a scramble key and scrambles the data using the scramble key to generate scrambled data, the scramble key having a Hamming weight of B/2 when B is an even number and having a Hamming weight of (B+1)/2 or (B-1)/2 when B is an odd number where B denotes a bus width of the data; and a transfer controller (20) that transfers the scrambled data to the transfer destination circuit (90).

## Description

### [Technical Field]

The present disclosure relates to a semiconductor integrated circuit and a data transfer method for scrambling data and transferring the data to a transfer destination circuit.

### [Background Art]

Conventionally, semiconductor integrated circuits, etc. that transfer data have been proposed (see, for example, Patent Literature (PTL) 1).

### [Citation List]

### [Patent Literature]

[PTL 1] Japanese Patent No. 5606527

### [Summary of Invention]

### [Technical Problem]

There are instances where, when transferring data, the signal quality of the transferred data is degraded depending on a data pattern.

In view of the above, the present disclosure provides a semiconductor integrated circuit, etc. capable of inhibiting the degradation of the signal quality of data that can be caused depending on the data pattern.

### [Solution to Problem]

A semiconductor integrated circuit according to the present disclosure is a semiconductor integrated circuit for scrambling data and transferring the data to a transfer destination circuit. The semiconductor integrated circuit includes: a scrambler that generates a scramble key and scrambles the data using the scramble key to generate scrambled data, the scramble key having a Hamming weight of B/2 when B is an even number and having a Hamming weight of (B+1)/2 or (B-1)/2 when B is an odd number where B denotes a bus width of the data; and a transfer controller that transfers the scrambled data to the transfer destination circuit.

A data transfer method according to the present disclosure is a data transfer method performed by a semiconductor integrated circuit for scrambling data and transferring the data to a transfer destination circuit. The data transfer method includes: generating a scramble key and scrambling the data using the scramble key to generate scrambled data, the scramble key having a Hamming weight of B/2 when B is an even number and having a Hamming weight of (B+1)/2 or (B-1)/2 when B is an odd number where B denotes a bus width of the data; and transferring the scrambled data to the transfer destination circuit.

General and specific aspects described above may be implemented using a system, a method, an integrated circuit, a computer program, or a computer-readable recording medium such as a compact disc read only memory (CD-ROM), or any combination of systems, methods, integrated circuits, computer programs, or computer-readable recording media.

### [Advantageous Effects of Invention]

With the semiconductor integrated circuit, etc. according to one aspect of the present disclosure, it is possible to inhibit the degradation of the signal quality of data that can be caused depending on a data pattern.

### [Brief Description of Drawings]

[FIG. 1A]

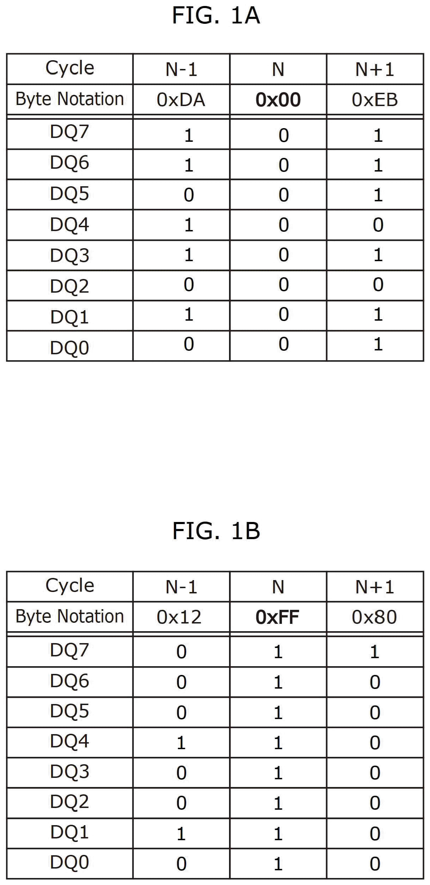

   FIG. 1A is a diagram for explaining a total number of simultaneous switching events between data of 0x00 and the preceding and following data.
[FIG. 1B]
   FIG. 1B is a diagram for explaining a total number of simultaneous switching events between data of 0xFF and the preceding and following data.
[FIG. 2]

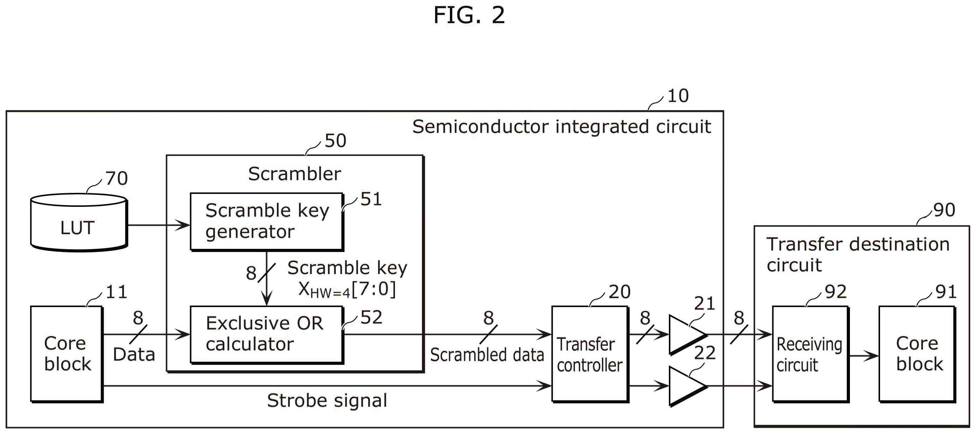

   FIG. 2 is a block diagram illustrating an example of a semiconductor integrated circuit according to Embodiment 1.
[FIG. 3]

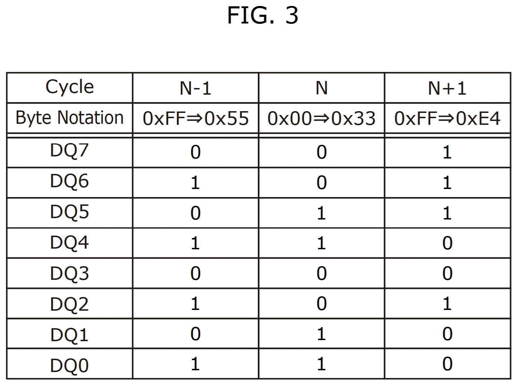

   FIG. 3 is a diagram for explaining a total number of the simultaneous switching events between data of 0x00 and the preceding and following data after scrambling is performed with a scramble key having Hamming weight of 4.
[FIG. 4]

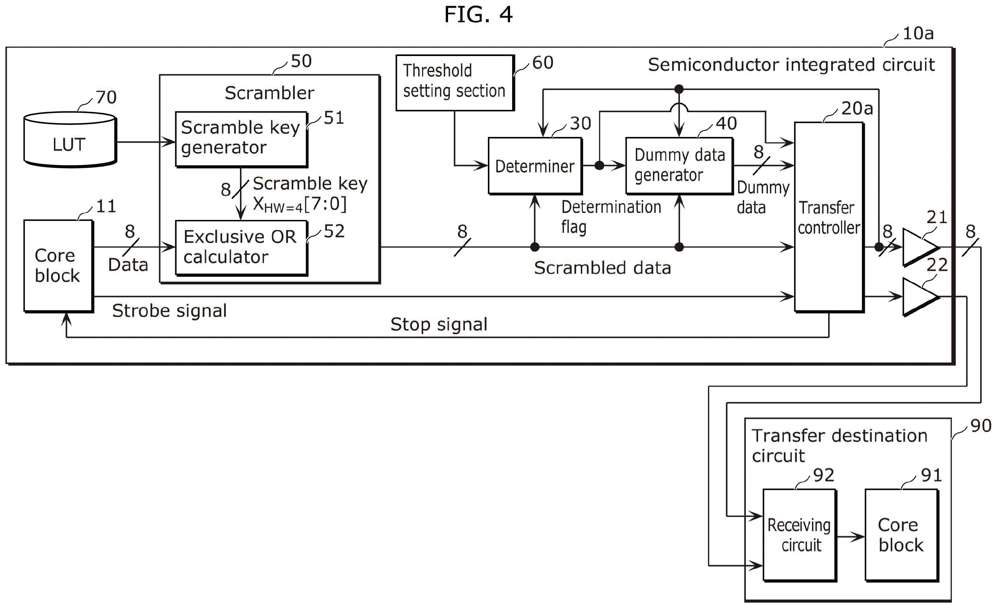

   FIG. 4 is a block diagram illustrating an example of a semiconductor integrated circuit according to Embodiment 2.
[FIG. 5]

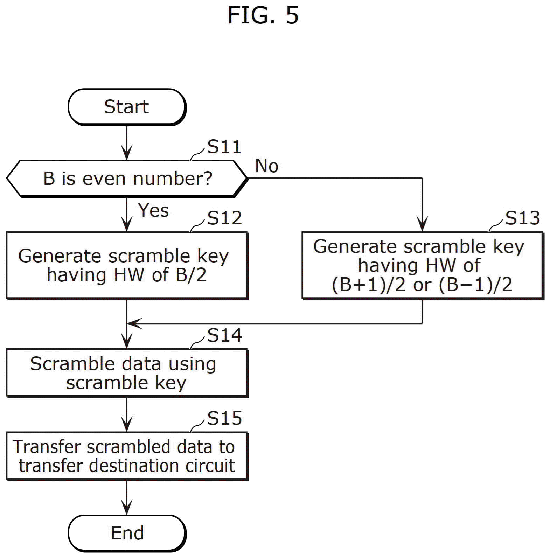

   FIG. 5 is a flowchart illustrating an example of a data transfer method according to the other embodiments.

### [Description of Embodiments]

### (Circumstances Leading to Obtaining One Aspect of the Present Disclosure)

Conventionally, a phenomenon is known where, when transferring data, the signal quality of the transferred data is degraded depending on a data pattern.

For example, there are instances where, when the data to be transferred is bus-format data including a plurality of bits, noise such as simultaneous switching noise (SSN, also referred to as power supply noise) is superimposed on to the data to be transferred due to the plurality of bits toggling simultaneously. Here, the simultaneous switching noise is noise in which, at the time when a plurality of bits toggle simultaneously; that is, at the time when a total number of simultaneous switching events increases, the electric potential of the power supply line such as a drive circuit that drives these bits fluctuates, and this fluctuation in the electric potential of the power supply line is superimposed on the data to be transferred. When simultaneous switching noise occurs, signal quality is degraded due to an increase in power supply noise or an increase in jitter, etc.

The total number of simultaneous switching events tends to be large particularly between data in which the logical values of all bits are 0 or 1, such as 0x00 or 0xFF in the data pattern, and preceding and following data. The following describes this with reference to FIG. 1A and FIG. 1B.

FIG. 1A is a diagram for explaining a total number of simultaneous switching events between data of 0x00 and the preceding and following data. FIG. 1B is a diagram for explaining a total number of simultaneous switching events between data of 0xFF and the preceding and following data.

For example, when data transfer is performed to a destination circuit by transferring data over a plurality of cycles, assume that the 8-bit data transferred in an N cycle is 0x00, as indicated in FIG. 1A. In addition, assume that the 8-bit data transferred in an N-1 cycle is 0xDA, and the 8-bit data transferred in an N+1 cycle is 0xEB. Between the data of the N-1 cycle and the data of the N cycle, the bits of DQ1, DQ3, DQ4, DQ6 and DQ7 have transitioned from a logical value of 1 to a logical value of 0, and thus the total number of simultaneous switching events from the logical value of 1 to the logical value of 0 is large as 5. In addition, between the data of the N cycle and the data of the N+1 cycle, the bits of DQ0, DQ1, DQ3, DQ5, DQ6 and DQ7 has transitioned from the logical value of 0 to the logical value of 1, and thus the total number of simultaneous switching events from the logical value of 0 to the logical value of 1 is large as 6.

In addition, for example, when data transfer is performed to a destination circuit by transferring data over a plurality of cycles, assume that the 8-bit data transferred in the N cycle is 0xFF, as indicated in FIG. 1B. In addition, assume that the 8-bit data transferred in the N-1 cycle is 0x12, and the 8-bit data transferred in the N+1 cycle is 0x80. Between the data of the N-1 cycle and the data of the N cycle, the bits of DQ0, DQ2, DQ3, DQ5, DQ6, and DQ7 have transitioned from the logical value of 0 to the logical value of 1, and the total number of simultaneous switching events from the logical value of 0 to the logical value of 1 is large as 6. In addition, between the data of the N cycle and the data of the N+1 cycle, the bits of DQ0, DQ1, DQ2, DQ3, DQ4, DQ5, and DQ6 have transitioned from the logical value of 1 to the logical value of 0, and the total number of simultaneous switching events from the logical value of 1 to the logical value of 0 is large as 7.

In general digital data, the appearance frequency of data in which the logical values of all bits are 0 or 1 is relatively high. This is because the data in which the logical values of all bits are 0 or 1 is used as a default value for parameters or used for padding or stuffing, etc. In addition, there also exists data, such as color bars, that contains a very large amount of data in which the logical values of all bits are 0 or 1.

As described above, in general digital data, the appearance frequency of data in which the logical values of all bits are 0 or 1 is high, and thus a total number of simultaneous switching events tends to be large. When the total number of simultaneous switching events is large at the time of transferring data, there are instances where simultaneous switching noise occurs and the signal quality of the transferred data is degraded.

In view of the above, the following describes a semiconductor integrated circuit, etc. capable of inhibiting the degradation of the signal quality of data that can be caused depending on the data pattern at the time of transferring data, specifically, a semiconductor integrated circuit, etc. capable of inhibiting the degradation of signal quality by reducing the total number of simultaneous switching events caused by data in which the logical values of all bits are 0 or 1.

Hereinafter, an embodiment will be described in detail with reference to the Drawings.

It should be noted that the embodiments described below each show a general or specific example. The numerical values, shapes, materials, structural components, the arrangement and connection of the structural components, steps, the processing order of the steps, and so on, indicated in the following embodiments are mere examples, and therefore do not limit the present disclosure.

### [Embodiment 1]

Hereinafter, a semiconductor integrated circuit according to Embodiment 1 will be described.

FIG. 2 is a block diagram illustrating an example of semiconductor integrated circuit 10 according to Embodiment 1. It should be noted that transfer destination circuit 90 is also illustrated in addition to semiconductor integrated circuit 10 in FIG. 2. For example, transfer destination circuit 90 is a circuit that is provided independently of semiconductor integrated circuit 10. For example, transfer destination circuit 90 includes memory.

Semiconductor integrated circuit 10 is a circuit for scrambling data and transferring the data to transfer destination circuit 90. This data is also referred to as transfer data. For example, the transfer data has a bus width of B bits (B is an integer greater than or equal to 2, B is 8 bits in FIG. 2), and can take any value such as data in which the logical values of all bits are 0 or 1. Semiconductor integrated circuit 10 scrambles the transfer data and transfers scrambled data resulting from scrambling the transfer data, to transfer destination circuit 90 for each of a plurality of cycles. In addition, semiconductor integrated circuit 10 transmits, to transfer destination circuit 90, a strobe signal for causing transfer destination circuit 90 to receive the scrambled data.

Semiconductor integrated circuit 10 includes core block 11, transfer controller 20, buffer 21, buffer 22, scrambler 50, and look-up table (LUT) 70.

Core block 11 generates transfer data of B bits to be transferred to transfer destination circuit 90, and outputs the transfer data generated to scrambler 50. At this time, core block 11 repeatedly generates transfer data and repeatedly outputs the transfer data.

In addition, each time transfer data is output, core block 11 outputs, to transfer controller 20, a strobe signal for causing transfer destination circuit 90 to receive the transfer data. Here, the strobe signal is, for example, a signal that is input to a clock input terminal of a flip-flop circuit for obtaining the data transferred in transfer destination circuit 90. In this case, the strobe signal may be, for example, a differential signal including 2 bits, or may be a signal of 1 bit.

Scrambler 50 scrambles the transfer data of B bits that has been output from core block 11. For example, scrambler 50 includes scramble key generator 51 and exclusive OR calculator 52.

Scramble key generator 51 generates a scramble key that is used at the time of scrambling transfer data. Scramble key generator 51, when the bus width of the transfer data is B, generates a scramble key having a Hamming weight of B/2 when B is an even number, and generates a scramble key having a Hamming weight of (B+1)/2 or (B-1)/2 when B is an odd number. The Hamming weight is a total number of non-zero symbols in a symbol sequence, in other words, a total number of 1s in a bit sequence. Hereinafter, a value that is B/2 when the bus width B is an even number, and a value that is (B+1)/2 or (B-1)/2 when the bus width B is an odd number are also referred to as "half the bus width". For example, when the bus width of the transfer data is 8, scramble key generator 51 generates a scramble key having a Hamming weight of 4 (for example, as illustrated in FIG. 2, scramble key X_{HW}=₄[7:0]). In addition, for example, when the bus width of the transfer data is 9, scramble key generator 51 generates a scramble key having a Hamming weight of 4 or 5. In FIG. 2, since the bus width B is 8 bits, a scramble key having a Hamming weight of 4 is generated.

Exclusive OR calculator 52 scrambles the transfer data by performing an exclusive OR operation between the transfer data and the scramble key. It should be noted that scrambler 50 may include an exclusive NOR calculator instead of exclusive OR calculator 52, and the exclusive NOR calculator may scramble the transfer data by performing an exclusive NOR operation between the transfer data and the scramble key.

As described above, by scrambling the transfer data by performing an exclusive OR operation or an exclusive NOR operation between transfer data in which the logical values of all bits are 0 or 1 and a scramble key having a Hamming weight that is half the bus width of the transfer data, the Hamming weight of the transfer data (scrambled data) can also be made to be half the bus width of the transfer data (strictly speaking, (B+1)/2 or (B-1)/2 when the bus width is an odd number).

Transfer controller 20 transfers scrambled data resulting from scrambling the transfer data to transfer destination circuit 90. Specifically, transfer controller 20 performs data transfer to transfer destination circuit 90 by transferring the scrambled data over a plurality of cycles as well as transmits a strobe signal for causing transfer destination circuit 90 to receive the scrambled data. More specifically, transfer controller 20 transfers the scrambled data of B bits that has been output from scrambler 50, to transfer destination circuit 90 via buffer 21 for each of the plurality of cycles, and transmits a strobe signal for causing transfer destination circuit 90 to receive the scrambled data to transfer destination circuit 90 via buffer 22.

For example, transfer controller 20 transfers scrambled data to the memory of transfer destination circuit 90. In other words, for example, transfer controller 20 write-transfers scrambled data to the memory of transfer destination circuit 90.

Transfer destination circuit 90 receives the scrambled data that has been transferred from semiconductor integrated circuit 10, by using the strobe signal transferred from semiconductor integrated circuit 10.

As illustrated in FIG. 2, transfer destination circuit 90 includes receiving circuit 92 and core block 91.

Receiving circuit 92 is configured by, for example, B flip-flop circuits into which the respective signals of the scrambled data of B bits are input through the data input terminals and the strobe signal is input through the respective clock input terminals.

With the above-described configuration, receiving circuit 92 receives the scrambled data transferred from semiconductor integrated circuit 10 at the time when the strobe signal (here, a differential signal including 2 bits) changes.

Core block 91 performs various signal processing using the scrambled data received by receiving circuit 92. For example, core block 91 stores the scrambled data in the memory of transfer destination circuit 90.

For example, scrambler 50 generates a scramble key based on a storage destination address of the scrambled data in the memory of transfer destination circuit 90. As illustrated in FIG. 2, LUT 70 may be stored in the memory included in semiconductor integrated circuit 10, and in LUT 70, each of a plurality of candidates for the storage destination address and each of a plurality of candidates for the scramble key are associated one-to-one. Scrambler 50 may generate a scramble key by looking up the storage destination address in such LUT 70. In this manner, it is possible to readily generate a scramble key simply by preparing LUT 70.

Note that each of a plurality of candidates for a portion of bits of storage destination addresses and each of a plurality of candidates for the scramble key may be associated in a one-to-one correspondence in LUT 70, and scrambler 50 may generate a scramble key by looking up a portion of bits of the storage destination address in such LUT 70. In this manner, by using a portion of bits rather than all bits of the storage destination address, it is possible to reduce the total number of candidates for the scramble key, enabling readily preparing LUT 70.

In addition, for example, transfer controller 20 obtains scrambled data from the memory of transfer destination circuit 90. In other words, for example, transfer controller 20 obtains scrambled data from the memory of transfer destination circuit 90 by read transfer.

For example, scrambler 50 generates a scramble key based on the storage destination address of the scrambled data obtained, and descrambles the obtained scrambled data using the scramble key. In this manner, it is possible to decrypt the scrambled data to obtain the transfer data before scrambling.

If the storage destination address of the scrambled data is known, a scramble key for descrambling this scrambled data can be generated, and thus a storage area for storing the scramble key used during scrambling becomes unnecessary. In other words, by utilizing the storage destination address that is required when performing write transfer and read transfer of data, it is not necessary to store the scramble key.

Next, advantageous effects yielded by scrambling transfer data with a scramble key having a Hamming weight that is half the bus width of the transfer data will be described with reference to FIG. 3.

FIG. 3 is a diagram for explaining a total number of simultaneous switching events between transfer data of 0x00 and the preceding and following transfer data, after transfer data is scrambled using a scramble key having a Hamming weight of 4 and an exclusive OR calculation.

For example, assume that when the transferring of transfer data (e.g., 8-bit data) is performed over a plurality of cycles, data that is transferred in an N-1 cycle is 0xFF, data that is transferred in an N cycle is 0x00, and data that is transferred in an N+1 cycle is 0xFF. Assume that scrambler 50 scrambles the transfer data of each cycle with a scramble key having a Hamming weight of 4, and that, by doing so, as illustrated in FIG. 3, scrambled data resulting from scrambling the data of 0xFF that is transferred in the N-1 with a scramble key of 0xAA is 0x55, scrambled data resulting from scrambling the data of 0x00 that is transferred in the N cycle with a scramble key of 0x33 is 0x33, and scrambled data resulting from scrambling the data of 0xFF transferred in the N+1 cycle with a scramble key of Ox1B is 0xE4.

As illustrated in FIG. 3, it can be seen that the Hamming weight of the scrambled data resulting from scrambling the transfer data with a scramble key having a Hamming weight of 4 is also 4. As a result, the total number of simultaneous switching events can be made less than or equal to 4.

Specifically, between the scrambled data of the N-1 cycle and the scrambled data of the N cycle, the bits of DQ1 and DQ5 have transitioned from a logical value of 0 to a logical value of 1, and thus the total number of simultaneous switching events from the logical value of 0 to the logical value of 1 is 2. In addition, between the scrambled data of the N-1 cycle and the scrambled data of the N cycle, the bits of DQ2 and DQ6 have transitioned from a logical value of 1 to a logical value of 0, and thus the total number of simultaneous switching events from the logical value of 1 to the logical value of 0 is 2.

In addition, between the scrambled data of the N cycle and the scrambled data of the N+1 cycle, the bits of DQ2, DQ6 ,and DQ7 have transitioned from a logical value of 0 to a logical value of 1, and thus the total number of simultaneous switching events from the logical value of 0 to the logical value of 1 is 3. In addition, between the scrambled data of the N cycle and the scrambled data of the N+1 cycle, the bits of DQ0, DQ1 ,and DQ4 have transitioned from a logical value of 1 to a logical value of 0, and thus the total number of simultaneous switching events from the logical value of 1 to the logical value of 0 is 3.

In this manner, by scrambling transfer data using a scramble key having a Hamming weight that is half the bus width of the transfer data, the total number of simultaneous switching events between the transfer data in which the logical values of all bits are 0 and the transfer data in which the logical values of all bits are 1 can be made half or less of the bus width of the transfer data.

For example, as a result of the total number of simultaneous switching events between the transfer data in which the logical values of all bits are 0 and the transfer data in which the logical values of all bits are 1 (e.g., the total number of simultaneous switching events from a logical value of 0 to a logical value of 1, or the total number of simultaneous switching events from a logical value of 1 to a logical value of 0) being half or less of the bus width of the transfer data, it is possible to inhibit simultaneous switching noise. For example, even when transfer data in which the logical values of all bits are 0 or 1 is scrambled with a scramble key having a Hamming weight that is not adjusted, there are instances where the total number of simultaneous switching events between the transfer data in which the logical values of all bits are 0 and the transfer data in which the logical values of all bits are 1 is half or less of the bus width of the transfer data. However, merely by scrambling transfer data with a scramble key having a Hamming weight that is not adjusted, there are instances where the total number of simultaneous switching events is more than half the bus width of the transfer data, making it impossible to inhibit simultaneous switching noise.

In contrast, by using a scramble key having a Hamming weight of B/2, or (B+1)/2 or (B-1)/2 (that is, a scramble key having a Hamming weight that is half the bus width of the transfer data) to scramble the transfer data in which the logical values of all bits are 0 or 1, it is possible to reduce the total number of simultaneous switching events between the transfer data in which the logical values of all bits are 0 and the transfer data in which the logical values of all bits are 1. This is because when the transfer data in which the logical values of all bits are 0 or 1 is scrambled with such a scramble key, the logical value of half of all bits of the transfer data (scrambled data) becomes 0, the logical value of the remaining half of the bits becomes 1, and the total number of simultaneous switching events is at most half the bus width of the transfer data. As a result, at the time of transferring transfer data, it is possible to inhibit the degradation of the signal quality of the transfer data that can be caused depending on a data pattern.

### [Embodiment 2]

Next, a semiconductor integrated circuit according to Embodiment 2 will be described.

FIG. 4 is a block diagram illustrating an example of semiconductor integrated circuit 10a according to Embodiment 2. It should be noted that transfer destination circuit 90 is also illustrated in addition to semiconductor integrated circuit 10a in FIG. 4. For example, transfer destination circuit 90 is a circuit that is provided independently of semiconductor integrated circuit 10a, and includes memory.

Semiconductor integrated circuit 10a differs from semiconductor integrated circuit 10 according to Embodiment 1 in that semiconductor integrated circuit 10a includes transfer controller 20a in place of transfer controller 20 and further includes determiner 30, dummy data generator 40, and threshold setting section 60. Other points are same as semiconductor integrated circuit 10 according to Embodiment 1. Accordingly, the same descriptions are omitted, and the following description focuses on the different points.

Transfer controller 20a transfers scrambled data resulting from scrambling the transfer data, to transfer destination circuit 90. Specifically, transfer controller 20a performs data transfer to transfer destination circuit 90 by transferring the scrambled data over a plurality of cycles as well as transmits a strobe signal for causing transfer destination circuit 90 to receive the scrambled data. More specifically, transfer controller 20a receives scrambled data of B bits output from scrambler 50, a strobe signal output from core block 11, dummy data of B bits output from dummy data generator 40 that will be described later, and a determination flag output from determiner 30 that will be described later. Transfer controller 20a transfers the transfer data of B bits to transfer destination circuit 90 via buffer 21 for each of a plurality of cycles, and transmits, to transfer destination circuit 90 via buffer 22, a strobe signal for causing transfer destination circuit 90 to receive the transfer data. Here, the transfer data is the scrambled data output from scrambler 50 or the dummy data output from dummy data generator 40. The dummy data refers to data that is not processed in transfer destination circuit 90 (here, receiving circuit 92). The determination flag is a flag indicating a determination result as to whether transfer controller 20a transmits dummy data. The determination is made before transfer controller 20a transfers, to transfer destination circuit 90, data to be transferred that is the latest scrambled data output from scrambler 50.

When a determination flag indicating a determination result that transfer controller 20a is not to transmit dummy data is output from determiner 30 before transfer controller 20a transfers the data to be transferred to transfer destination circuit 90, transfer controller 20a transfers the data to be transferred to transfer destination circuit 90 and transmits a strobe signal to transfer destination circuit 90. In this case, transfer destination circuit 90 receives the scrambled data transferred from transfer controller 20a.

When a determination flag indicating a determination result that transfer controller 20a is to transmit dummy data is output from determiner 30 before transfer controller 20a transfers the data to be transferred to transfer destination circuit 90, transfer controller 20a transmits the dummy data to transfer destination circuit 90 and inhibits transmission of the strobe signal for causing transfer destination circuit 90 to receive the dummy data. In this case, transfer destination circuit 90 does not receive the dummy data transferred from transfer controller 20a.

Furthermore, when a determination flag indicating a determination result that transfer controller 20a is to transmit dummy data is output from determiner 30 before transfer controller 20a transfers the data to be transferred to transfer destination circuit 90, transfer controller 20a outputs a stop signal to core block 11 for stopping output of next transfer data for one cycle.

Determiner 30 receives: scrambled data to be transferred that has been output from scrambler 50, and is to be transferred next by transfer controller 20a; and already-transferred scrambled data that has been output from transfer controller 20a, and was transferred in the most recent cycle among data previously transferred by transfer controller 20a. Determiner 30 determines whether a total number of bits transitioning from a logical value of 0 to a logical value of 1, or a total number of bits transitioning from a logical value of 1 to a logical value of 0, between the scrambled data to be transferred and the already-transferred scrambled data transferred in the most recent cycle, is greater than a predetermined threshold (e.g., 4).

For example, the predetermined threshold may be a variable, and threshold setting section 60 may set the predetermined threshold. Specifically, when B is an even number, threshold setting section 60 sets the predetermined threshold to greater than or equal to B/2, and when B is an odd number, threshold setting section 60 sets the predetermined threshold to greater than or equal to (B+1)/2. For example, when the bus width of the transfer data is 8, threshold setting section 60 sets the predetermined threshold to greater than or equal to 4, and when the bus width of the transfer data is 9, sets the predetermined threshold to 5. As a result, it is possible to set conditions under which scrambled data is not transferred and dummy data is transmitted.

Note that semiconductor integrated circuit 10a need not necessarily include threshold setting section 60, and the predetermined threshold may be a value determined in advance (fixed value).

Dummy data generator 40 receives: scrambled data to be transferred that has been output from scrambler 50, and is to be transferred next by transfer controller 20a; already-transferred scrambled data that has been output from transfer controller 20a, and was transferred in the most recent cycle among data previously transferred by transfer controller 20a; and a determination flag output from determiner 30, generates dummy data by a predetermined method, and outputs the dummy data generated to transfer controller 20a.

Dummy data generator 40 generates dummy data such that the total number of simultaneous switching events between the scrambled data and the dummy data is at most half the bus width of the transfer data.

For example, dummy data generator 40 may generate dummy data including first bits that are K bits (where K is half the bus width) out of B bits in the data to be transferred, and second bits that are B-K bits, excluding the first bits described above, out of B bits in the latest already-transferred data.

In addition, for example, dummy data generator 40 may generate dummy data having a predetermined Hamming weight that is halt the half the bus width.

When the logical values of all bits of the transfer data are 0 or 1, the total number of bits transitioning from a logical value of 0 to a logical value of 1, or the total number of bits transitioning from a logical value of 1 to a logical value of 0, between the scrambled data to be transferred and the already-transferred scrambled data transferred in the most recent cycle is less than or equal to a predetermined threshold (e.g., 4). This is because, as decried in Embodiment 1, the transfer data is scrambled using a scramble key having a Hamming weight that is half the bus width of the transfer data.

On the other hand, there are instances where transfer data in which the logical values of all bits are not all 0 or not all 1 is input to semiconductor integrated circuit 10a. In such a case, there are instances where the total number of bits transitioning from a logical value of 0 to a logical value of 1, or the total number of bits transitioning from a logical value of 1 to a logical value of 0, between the scrambled data to be transferred and the already-transferred scrambled data transferred in the most recent cycle is greater than a predetermined threshold (e.g., 4).

In view of the above, when determiner 30 has determined that the total number of bits transitioning from a logical value of 0 to a logical value of 1 or the total number of bits transitioning from a logical value of 1 to a logical value of 0 is greater than the predetermined threshold, transfer controller 20a transmits dummy data to transfer destination circuit 90 and performs invalidation processing to invalidate the dummy data in transfer destination circuit 90, before transferring the scrambled data to be transferred to transfer destination circuit 90.

Determiner 30 is capable of determining, based on the data to be transferred and the already-transferred data, whether there is a relatively high risk of noise that can be caused depending on a data pattern being superimposed on data to be transferred in the cycle in which the data to be transferred is scheduled to be transferred. Accordingly, when there is a relatively high risk of this, determiner 30 can determine that transfer controller 20a is to transmit dummy data to transfer destination circuit 90 before transfer controller 20a transfers data to be transferred to transfer destination circuit 90. When determiner 30 has made such a determination, transfer controller 20a then transfers the dummy data to transfer destination circuit 90 before transferring the data to be transferred. In other words, when there is a relatively high risk of noise that can be caused depending on a data pattern being superimposed on data to be transferred in the cycle in which the data to be transferred is scheduled to be transferred, transfer controller 20a transmits dummy data without transferring the data to be transferred. As a result, even when the transfer data in which the logical values of all bits are not all 0 or not all 1 is input to semiconductor integrated circuit 10a, and thus the total number of simultaneous switching events can be more than half the bus width of the transfer data, it is possible to inhibit the degradation of the signal quality of the transfer data that can be caused depending on the data pattern when transferring the transfer data.

### (Other Embodiments)

Embodiments are described thus far as exemplifications of the technique according to the present disclosure. However, the technique according to the present disclosure is not limited to the foregoing embodiments, and can also be applied to embodiments to which a change, substitution, addition, or omission is executed as necessary. For example, the following variation examples are also included in one embodiment of the present disclosure.

For example, FIG. 2 and FIG. 4 illustrate the cases where the bus width of transfer data is 8 bits, but the bus width of transfer data is not limited to 8 bits.

For example, scrambler 50 may further attach a scramble key to the beginning or to the end of the scrambled data. In this manner, since it is possible to descramble the scrambled data by using the scramble key attached to the scrambled data, a storage area for storing the scramble key used during scrambling becomes unnecessary.

For example, transfer destination circuit 90 may be a circuit that does not include memory, such as a display, and the transfer data may be image data, video data, or the like.

For example, although the foregoing embodiments have described an example in which a scramble key is generated using LUT 70, the present disclosure is not limited to this example. For example, a scramble key may be generated by randomly selecting one scramble key from a plurality of candidates for the scramble key prepared in advance.

Embodiment 2 has described an example in which, when a determination flag indicating a determination result that transfer controller 20a is to transmit dummy data is output from determiner 30 before transfer controller 20a transfers the data to be transferred to transfer destination circuit 90, transfer controller 20a performs the processing of inhibiting the transmission of a strobe signal for causing transfer destination circuit 90 to receive the dummy data, as an invalidation processing for invalidating the dummy data in transfer destination circuit 90.

In contrast, when a determination flag indicating a determination result that transfer controller 20a is to transmit dummy data is output from determiner 30 before transfer controller 20a transfers the data to be transferred to transfer destination circuit 90, transfer controller 20a may perform the processing of causing transfer destination circuit 90 to invalidate the dummy data, by transmitting to transfer destination circuit 90 an invalidation flag signal for invalidating the dummy data in transfer destination circuit 90, as the invalidation processing for invalidating the dummy data in transfer destination circuit 90. At this time, transfer controller 20a may transmit a strobe signal to transfer destination circuit 90 without performing the processing of inhibiting the transmission of the strobe signal for causing transfer destination circuit 90 to receive the dummy data.

On the other hand, when a determination flag indicating a determination result that transfer controller 20a is not to transmit dummy data is output from determiner 30 before transfer controller 20a transfers the data to be transferred to transfer destination circuit 90, transfer controller 20a transfers the data to be transferred to transfer destination circuit 90 and transmits a strobe signal to transfer destination circuit 90. In this case, transfer controller 20a does not transmit an invalidation flag signal to transfer destination circuit 90.

In this manner, the scrambled data transferred from semiconductor integrated circuit 10a is input to core block 91, while the dummy data is not input thereto. As a result, it is possible to invalidate the dummy data in transfer destination circuit 90.

For example, the present disclosure can be implemented not only as a semiconductor integrated circuit but also as a data transfer method including the steps (processes) performed by the structural components included in the semiconductor integrated circuit.

FIG. 5 is a flowchart illustrating an example of a data transfer method according to the other embodiments.

The data transfer method is a data transfer method executed by a semiconductor integrated circuit for scrambling data and transferring the data to a destination circuit. The data transfer method includes: as illustrated in FIG. 5, when a bus width of the data is B, generating a scramble key having a Hamming weight of B/2 (step S12) if B is an even number (Yes in step S11); generating a scramble key having a Hamming weight of (B+1)/2 or (B-1)/2 (step S13) if B is an odd number (No in step S11); a step of scrambling the data using the scramble key (step S14); and a step of transferring scrambled data resulting from the scrambling, to the transfer destination circuit (step S15).

For example, the present disclosure can be implemented as a program for causing a computer (processor) to execute the steps included in the data transfer method. In addition, the present disclosure can be implemented as a non-transitory computer-readable recording medium such as a compact disc-read only memory (CD-ROM) including the program recorded thereon.

For example, when the present disclosure is implemented by a program (software), each of the steps is performed as a result of the program being executed by utilizing hardware resources such as a CPU, memory, an input and output circuit, etc. of a computer. In other words, each step is executed by the CPU obtaining data from memory or an input and output circuit, etc., performing calculations, and outputting calculation results to memory or input and output circuit, etc.

It should be noted that each of the structural components included in the semiconductor integrated circuit in the above-described embodiment may be configured as dedicated hardware, or may be implemented by executing a software program suitable for the structural components. Each of the structural components may be implemented by means of a program executing unit, such as a CPU or a processor, reading and executing the software program recorded on a recording medium such as a hard disk or a semiconductor memory.

Some or all of the functions of the semiconductor integrated circuit according to the above-described embodiment are typically implemented as LSIs which are integrated circuits. They may be implemented as a single chip one-by-one, or as a single chip to include some or all thereof. In addition, the integrated circuit is not limited to an LSI, and it may be implemented as a dedicated circuit or a general-purpose processor. A field programmable gate array (FPGA) that is programmable after an LSI is manufactured or a reconfigurable processor that is capable of reconfiguring connection and settings of circuit cells inside an LSI may be employed.

Furthermore, in the future, with advancement in semiconductor technology, a brand-new technology may replace LSI. The structural components included in the semiconductor integrated circuit each can be integrated using such a technology.

It should be noted that the present disclosure also includes other forms in which various modifications apparent to those skilled in the art are applied to the embodiments or forms in which structural components and functions in the embodiments are arbitrarily combined within the scope of the present disclosure.

### (Others)

The descriptions of the embodiments described above disclose the following techniques.

(Technique 1) A semiconductor integrated circuit for scrambling data and transferring the data to a transfer destination circuit. The semiconductor integrated circuit includes: a scrambler that generates a scramble key and scrambles the data using the scramble key to generate scrambled data, the scramble key having a Hamming weight of B/2 when B is an even number and having a Hamming weight of (B+1)/2 or (B-1)/2 when B is an odd number where B denotes a bus width of the data; and a transfer controller that transfers the scrambled data to the transfer destination circuit.

For example, as a result of the total number of simultaneous switching events between the data in which the logical values of all bits are 0 and the data in which the logical values of all bits are 1 (e.g., the total number of simultaneous switching events from a logical value of 0 to a logical value of 1, or the total number of simultaneous switching events from a logical value of 1 to a logical value of 0) being less than or equal to half the bus width of the data (strictly speaking, less than or equal to (B+1)/2 when the bus width is an odd number), it is possible to inhibit simultaneous switching noise. For example, even when the data in which the logical values of all bits are 0 or 1 is scrambled with a scramble key having a Hamming weight that is not adjusted, there are instances where the total number of simultaneous switching events between the data in which the logical values of all bits are 0 and the data in which the logical values of all bits are 1 is less than or equal to half the bus width of the data. However, merely by scrambling the data with a scramble key having a Hamming weight that is not adjusted, the total number of simultaneous switching events may be more than half the bus width of the data, and simultaneous switching noise may not be inhibited in some cases.

In contrast, by scrambling data in which the logical values of all bits are 0 or 1, using a scramble key having a Hamming weight of B/2, or (B+1)/2 or (B-1)/2 (hereinafter also referred to as a scramble key having a Hamming weight that is half the bus width of data), it is possible to reduce the total number of simultaneous switching events between the data in which the logical values of all bits are 0 and the data in which the logical values of all bits are 1. This is because when the data in which the logical values of all bits are 0 or 1 is scrambled with such a scramble key, the logical value of half of all bits of the data becomes 0, the logical value of the remaining half of the bits becomes 1, and the total number of simultaneous switching events is at most half the bus width of the data. As a result, at the time of transferring data, it is possible to inhibit the degradation of the signal quality of the data that can be caused depending on a data pattern.

(Technique 2) The semiconductor integrated circuit according to Technique 1, in which the scrambler scrambles the data by performing an exclusive OR operation or an exclusive NOR operation, between the data and the scramble key.

In this manner, by scrambling data in which the logical values of all bits are 0 or 1 by performing an exclusive OR operation or an exclusive NOR operation between the data and the scramble key, the Hamming weight of the data can also be half the bus width of the data.

(Technique 3) The semiconductor integrated circuit according to Technique 1 or 2, in which the transfer controller transmits the scrambled data to memory of the transfer destination circuit, and the scrambler generates the scramble key based on a storage destination address of the scrambled data in the memory.

According to this, it is possible to generate a scramble key according to the storage destination address of data.

(Technique 4) The semiconductor integrated circuit according to Technique 3, in which the scrambler generates the scramble key by looking up the storage destination address in a look-up table in which a plurality of candidates for the storage destination address and a plurality of candidates for the scramble key are associated with each other in a one-to-one correspondence.

In this manner, it is possible to readily generate a scramble key simply by preparing a look-up table.

(Technique 5) The semiconductor integrated circuit according to Technique 3, in which the scrambler generates the scramble key by looking up a portion of bits of the storage destination address in a look-up table in which a plurality of candidates for the portion of bits of the storage destination address and a plurality of candidates for the scramble key are associated with each other in a one-to-one correspondence.

In this manner, it is possible to readily generate a scramble key simply by preparing a look-up table. In addition, by using a portion of bits rather than all bits of the storage destination address, it is possible to reduce the total number of candidates for the scramble key, and to readily prepare a look-up table.

(Technique 6) The semiconductor integrated circuit according to any one of Techniques 3 to 5, in which the transfer controller further obtains the scrambled data from the memory, and the scrambler generates the scramble key based on the storage destination address of the scrambled data obtained, and descrambles the scrambled data obtained, using the scramble key.

In this manner, if the storage destination address of the scrambled data is known, a scramble key for descrambling this scrambled data can be generated, and thus a storage area for storing the scramble key used during scrambling becomes unnecessary.

(Technique 7) The semiconductor integrated circuit according to any one of Techniques 1 to 5, in which the scrambler further attaches the scramble key to a beginning or an end of the scrambled data.

In this manner, since it is possible to descramble the scrambled data by using the scramble key attached to the scrambled data, a storage area for storing the scramble key used during scrambling becomes unnecessary.

(Technique 8) The semiconductor integrated circuit according to any one of Techniques 1 to 7, in which the transfer controller performs data transfer to the transfer destination circuit by transferring the scrambled data over a plurality of cycles, and transmits a strobe signal to the transfer destination circuit, the strobe signal being for causing the transfer destination circuit to receive the scrambled data, the semiconductor integrated circuit further comprises: a determiner that determines whether a total number of bits transitioning from a logical value of 0 to a logical value of 1 or a total number of bits transitioning from a logical value of 1 to a logical value of 0 is greater than a predetermined threshold, between, among the scrambled data, scrambled data to be transferred next by the transfer controller and already-transferred scrambled data transferred in a most recent cycle among data previously transferred by the transfer controller; and a dummy data generator that generates dummy data, and the transfer controller, when the determiner has determined that the total number of bits transitioning from the logical value of 0 to the logical value of 1 or the total number of bits transitioning from the logical value of 1 to the logical value of 0 is greater than the predetermined threshold, transfers the dummy data to the transfer destination circuit and performs an invalidation processing for invalidating the dummy data in the transfer destination circuit, before transferring the scrambled data to be transferred to the transfer destination circuit.

There are instances where data in which the logical values of all bits are not all 0 or not all 1 is input to the semiconductor integrated circuit. When data in which the logical values of all bits are not all 0 or not all 1 is scrambled using a scramble key having a Hamming weight that is half the bus width of the data, there are instances where a total number of simultaneous switching events is more than half the bus width of the data, making it impossible to inhibit the simultaneous switching noise in some cases. In view of the above, dummy data is used in such a case.

Specifically, the determiner is capable of determining, based on the data to be transferred and the already-transferred data, whether there is a relatively high risk of noise that can be caused depending on a data pattern being superimposed on the data to be transferred in the cycle in which the data to be transferred is scheduled to be transferred. Accordingly, when there is a relatively high risk of that, the determiner is capable of determining that the transfer controller transmits dummy data to the transfer destination circuit, before the transfer controller transfers the data to be transferred to the transfer destination circuit. When the determiner has made such a determination, the transfer controller then transmits the dummy data to the transfer destination circuit before transferring the data to be transferred. In other words, when there is a relatively high risk of noise that can be caused depending on a data pattern being superimposed on data to be transferred in the cycle in which the data to be transferred is scheduled to be transferred, the transfer controller transmits dummy data without transferring the data to be transferred. As a result, even when the data in which the logical values of all bits are not all 0 or not all 1 is provided to the semiconductor integrated circuit, and thus the total number of simultaneous switching events can be more than half the bus width of the data, it is possible to inhibit the degradation of the signal quality of the transfer data that can be caused depending on the data pattern at the time of transferring the data.

(Technique 9) The semiconductor integrated circuit according to Technique 8 further includes a threshold setting section that sets the predetermined threshold. In the semiconductor integrated circuit, the threshold setting section: sets the predetermined threshold to be greater than or equal to B/2 when B is an even number; and sets the predetermined threshold to be greater than or equal to (B+1)/2 when B is an odd number.

According to this, it is possible to set conditions under which scrambled data is not transferred and dummy data is transmitted.

(Technique 10) A data transfer method performed by a semiconductor integrated circuit for scrambling data and transferring the data to a transfer destination circuit. The data transfer method includes: generating a scramble key and scrambling the data using the scramble key to generate scrambled data, the scramble key having a Hamming weight of B/2 when B is an even number and having a Hamming weight of (B+1)/2 or (B-1)/2 when B is an odd number where B denotes a bus width of the data; and transferring the scrambled data to the transfer destination circuit.

In this manner, when transferring data, it is possible to provide a data transfer method that enables inhibiting the degradation of the signal quality of the data that can be caused depending on a data pattern.

### [Industrial Applicability]

The present disclosure is applicable to semiconductor integrated circuits, etc. that transfer data.

### [Reference Signs List]

- 10, 10a: semiconductor integrated circuit
- 11, 91: core block
- 20, 20a: transfer controller
- 21, 22: buffer
- 30: determiner
- 40: dummy data generator
- 50: scrambler
- 51: scramble key generator
- 52: exclusive OR calculator
- 60: threshold setting section
- 70: LUT
- 90: transfer destination circuit
- 92: receiving circuit

## Claims

1. A semiconductor integrated circuit for scrambling data and transferring the data to a transfer destination circuit, the semiconductor integrated circuit comprising:
a scrambler that generates a scramble key and scrambles the data using the scramble key to generate scrambled data, the scramble key having a Hamming weight of B/2 when B is an even number and having a Hamming weight of (B+1)/2 or (B-1)/2 when B is an odd number where B denotes a bus width of the data; and
a transfer controller that transfers the scrambled data to the transfer destination circuit.

2. The semiconductor integrated circuit according to claim 1, wherein
the scrambler scrambles the data by performing an exclusive OR operation or an exclusive NOR operation, between the data and the scramble key.

3. The semiconductor integrated circuit according to claim 1 or 2, wherein
the transfer controller transmits the scrambled data to memory of the transfer destination circuit, and
the scrambler generates the scramble key based on a storage destination address of the scrambled data in the memory.

4. The semiconductor integrated circuit according to claim 3, wherein
the scrambler generates the scramble key by looking up the storage destination address in a look-up table in which a plurality of candidates for the storage destination address and a plurality of candidates for the scramble key are associated with each other in a one-to-one correspondence.

5. The semiconductor integrated circuit according to claim 3, wherein
the scrambler generates the scramble key by looking up a portion of bits of the storage destination address in a look-up table in which a plurality of candidates for the portion of bits of the storage destination address and a plurality of candidates for the scramble key are associated with each other in a one-to-one correspondence.

6. The semiconductor integrated circuit according to any one of claims 3 to 5, wherein
the transfer controller further obtains the scrambled data from the memory, and
the scrambler generates the scramble key based on the storage destination address of the scrambled data obtained, and descrambles the scrambled data obtained, using the scramble key.

7. The semiconductor integrated circuit according to any one of claims 1 to 5, wherein
the scrambler further attaches the scramble key to a beginning or an end of the scrambled data.

8. The semiconductor integrated circuit according to any one of claims 1 to 7, wherein
the transfer controller performs data transfer to the transfer destination circuit by transferring the scrambled data over a plurality of cycles, and transmits a strobe signal to the transfer destination circuit, the strobe signal being for causing the transfer destination circuit to receive the scrambled data,
the semiconductor integrated circuit further comprises:
a determiner that determines whether a total number of bits transitioning from a logical value of 0 to a logical value of 1 or a total number of bits transitioning from a logical value of 1 to a logical value of 0 is greater than a predetermined threshold, between, among the scrambled data, scrambled data to be transferred next by the transfer controller and already-transferred scrambled data transferred in a most recent cycle among data previously transferred by the transfer controller; and
a dummy data generator that generates dummy data, and
the transfer controller, when the determiner has determined that the total number of bits transitioning from the logical value of 0 to the logical value of 1 or the total number of bits transitioning from the logical value of 1 to the logical value of 0 is greater than the predetermined threshold, transfers the dummy data to the transfer destination circuit and performs an invalidation processing for invalidating the dummy data in the transfer destination circuit, before transferring the scrambled data to be transferred to the transfer destination circuit.

9. The semiconductor integrated circuit according to claim 8, further comprising:
a threshold setting section that sets the predetermined threshold, wherein
the threshold setting section:
sets the predetermined threshold to be greater than or equal to B/2 when B is an even number; and
sets the predetermined threshold to be greater than or equal to (B+1)/2 when B is an odd number.

10. A data transfer method performed by a semiconductor integrated circuit for scrambling data and transferring the data to a transfer destination circuit, the data transfer method comprising:
generating a scramble key and scrambling the data using the scramble key to generate scrambled data, the scramble key having a Hamming weight of B/2 when B is an even number and having a Hamming weight of (B+1)/2 or (B-1)/2 when B is an odd number where B denotes a bus width of the data; and
transferring the scrambled data to the transfer destination circuit.
